(19) Europäisches Patentamt / European Patent Office / Office européen des brevets

(11) **EP 2 998 981 B1**

(12) **FASCICULE DE BREVET EUROPEEN**

(45) Date de publication et mention
de la délivrance du brevet:
**31.01.2018 Bulletin 2018/05**

(51) Int Cl.:
***H01L 21/027*** *(2006.01)*     ***H01L 21/033*** *(2006.01)*
*G03F 7/00* *(2006.01)*

(21) Numéro de dépôt: **15184773.8**

(22) Date de dépôt: **11.09.2015**

(54) **PROCÉDÉ DE GRAPHO-ÉPITAXIE POUR RÉALISER DES MOTIFS À LA SURFACE D'UN SUBSTRAT**

GRAPHO-EPITAXIE-VERFAHREN ZUR UMSETZUNG VON MOTIVEN AUF DER OBERFLÄCHE EINES SUBSTRATS

GRAPHOEPITAXY METHOD FOR CREATING PATTERNS ON THE SURFACE OF A SUBSTRATE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.09.2014 FR 1458748**

(43) Date de publication de la demande:
**23.03.2016 Bulletin 2016/12**

(73) Titulaire: **COMMISSARIAT À L'ÉNERGIE ATOMIQUE ET AUX ÉNERGIES ALTERNATIVES**
**75015 Paris (FR)**

(72) Inventeurs:
• **PIMENTA BARROS, Patricia**
**38000 GRENOBLE (FR)**
• **TIRON, Raluca**
**38950 SAINT-MARTIN-LE-VINOUX (FR)**
• **CHEVALIER, Xavier**
**38100 GRENOBLE (FR)**
• **GHARBI, Ahmed**
**38000 GRENOBLE (FR)**

(74) Mandataire: **Cabinet Camus Lebkiri**
**25 rue de Maubeuge**
**75009 Paris (FR)**

(56) Documents cités:
**WO-A1-2013/146538     US-A1- 2014 021 166
US-A1- 2014 057 443**

• **DELALANDE MICHAËL ET AL: "Development of plasma etching processes to pattern sub-15 nm features with PS-b-PMMA block copolymer masks: Application to advanced CMOS techno", JOURNAL OF VACUUM SCIENCE & TECHNOLOGY B: MICROELECTRONICS AND NANOMETER STRUCTURES, AMERICAN INSTITUTE OF PHYSICS, 2 HUNTINGTON QUADRANGLE, MELVILLE, NY 11747, vol. 32, no. 5, 1 janvier 1901 (1901-01-01), XP012189919, ISSN: 2166-2746, DOI: 10.1116/1.4895334 [extrait le 1901-01-01]**

## Description

## DOMAINE TECHNIQUE

La présente invention concerne les techniques d'auto-assemblage dirigé de copolymères à blocs (« Directed Self-Assembly », DSA) afin de générer des motifs de très hautes résolution et densité. L'invention concerne plus particulièrement un procédé de réalisation de motifs à la surface d'un substrat, tels que des trous de contact ou des tranchées, en utilisant des copolymères à blocs.

## ETAT DE LA TECHNIQUE

Les besoins de procédés pour réaliser des motifs de dimensions nanométriques ont fortement augmenté ces dernières années, en raison de la tendance à la miniaturisation des composants électroniques.

Initialement, les motifs étaient réalisés par lithographie optique par projection. Dans ce procédé de réalisation, une couche photosensible est déposée sur un substrat, puis exposée à un faisceau ultraviolet à travers un masque définissant les motifs. La taille du plus petit motif réalisable (aussi appelée dimension critique « CD » pour « Critical Dimension » en anglais) est étroitement liée à la longueur d'onde du faisceau utilisé : plus la longueur d'onde est courte, plus le motif réalisé peut être fin et plus la densité d'intégration de ces motifs dans un circuit intégré peut être importante.

Les faisceaux ultraviolets utilisés en photolithographie ont classiquement une longueur d'onde de 193 nm ou 248 nm. Ce procédé de définition de motifs présente l'avantage d'être bien maitrisé et moins coûteux que d'autres procédés, notamment les procédés de lithographie électronique. Toutefois, avec de telles longueurs d'onde, la résolution de l'outil d'exposition est limitée.

Afin de réaliser des motifs plus fins, mieux résolus, et donc d'augmenter encore la densité d'intégration, de nouveaux procédés ont été développés, comme la photolithographie double exposition (« double-patterning »), la lithographie Extrême UltraViolet (EUV) et la lithographie par faisceau d'électrons (« e-beam »).

Parmi les technologies de lithographie émergentes, on peut également citer les techniques d'auto-assemblage dirigé de copolymères à blocs (« Directed Self-Assembly, DSA). Les copolymères à blocs sont des polymères dans lesquels deux unités de répétition, un monomère A et un monomère B, forment des chaînes liées entre elles par une liaison covalente. Lorsque l'on donne suffisamment de mobilité aux chaînes, par exemple en chauffant ces copolymères à blocs, la chaîne A et la chaîne B ont tendance à se séparer en phases ou blocs et à se réorganiser sous des conformations spécifiques, qui dépendent notamment du ratio entre le monomère A et le monomère B. En fonction de ce ratio, on peut par exemple avoir des sphères du monomère A dans une matrice du monomère B, ou bien des cylindres de A dans une matrice de B, ou encore des lamelles de A et des lamelles de B intercalées. La taille des domaines du bloc A (respectivement du bloc B) est directement proportionnelle à la longueur des chaines du monomère A (respectivement du monomère B). Les copolymères à blocs ont donc la propriété de former des motifs qui peuvent être contrôlés grâce au ratio de monomères.

Les techniques connues d'auto-assemblage de copolymères à blocs peuvent être regroupées en deux catégories, la grapho-épitaxie et la chémi-épitaxie, toutes deux décrites en détail dans l'article ["Guided self-assembly of block-copolymer for CMOS technology: a comparative study between grapho-epitaxy and surface chemical modification", L. Oria et al., SPIE 2011, Vol. 7970-24].

La chémi-épitaxie consiste à modifier les propriétés chimiques de certaines portions du substrat, pour forcer l'organisation des blocs de copolymère entre ces portions. Ces portions du substrat modifiées chimiquement sont typiquement délimitées par une étape de photolithographie suivie par une étape de plasma.

Alternativement, la grapho-épitaxie consiste à former des motifs primaires appelés guides à la surface d'un substrat, ces motifs délimitant des zones à l'intérieur desquelles une couche de copolymère à blocs est déposée. Les motifs de guidage permettent de contrôler l'organisation des blocs de copolymère pour former des motifs secondaires de plus haute résolution à l'intérieur de ces zones. Les motifs de guidage sont classiquement formés par photolithographie dans une couche de résine, et éventuellement, transférés dans un masque dur.

La technique de grapho-épitaxie a été récemment utilisée pour former des trous de contact dans un circuit intégré. Après dépôt et assemblage du copolymère à blocs dans les motifs de guidage, les motifs secondaires sont développés en retirant sélectivement l'un des deux blocs du copolymère (par exemple les cylindres de A), formant ainsi des trous dans la couche restante de copolymère (la matrice de B). Puis, ces trous sont transférés par gravure à la surface du substrat, généralement dans une couche diélectrique.

Grâce à cette technique, on peut réduire la dimension des motifs (application dite « contact shrink » en anglais), le motif secondaire étant de plus faibles dimensions que le motif primaire, i.e. le motif de guidage. Il n'y a alors qu'un seul trou de contact par motif de guidage. On peut aussi multiplier le nombre de motifs, en formant plusieurs trous de contact par motif de guidage (« contact multiplication »).

Comme discuté dans l'article ["Etch challenges for DSA implementation in CMOS via patterning", P. Pimenta Barros et al., SPIE Proceedings Vol. 9054, March 2014], les procédés actuels de grapho-épitaxie sont dépendants de la densité des motifs de guidage sur le substrat. En effet, le remplissage des motifs de guidage se faisant par dépôt à la tournette (« spin coating » en anglais), l'épaisseur de la couche de copolymère à blocs à l'intérieur d'un motif de guidage dépend de sa superficie, de son rapport de forme (profondeur/largeur) et du nombre de motifs de guidage à proximité. Par conséquent, pour des motifs de guidage de mêmes dimensions, l'épaisseur de la couche de copolymère dans un motif isolé est supérieure à l'épaisseur obtenue dans une pluralité de motifs rapprochés.

Or, l'épaisseur de la couche de copolymère dans les guides d'assemblage affecte le transfert des motifs par gravure, car la couche de copolymère sert de masque de gravure. Si dans certains guides d'assemblage l'épaisseur de copolymère est trop faible, une augmentation de la dimension critique des motifs peut se produire lors de leur transfert, car le masque de gravure est insuffisant. A l'inverse, lorsque l'épaisseur de copolymère est trop importante, des trous de contact peuvent manquer, leur transfert ayant échoué.

L'épaisseur de la couche de copolymère affecte également l'étape d'auto-assemblage du copolymère à blocs. En effet, une épaisseur trop faible ou trop importante de la couche de copolymère dans les guides peut entrainer une mauvaise organisation des blocs. En particulier, certains motifs de polymère peuvent ne pas s'orienter perpendiculairement au substrat. En général, ces défauts d'assemblage concernent les guides isolés, où l'épaisseur de copolymère à blocs est la plus importante.

Ainsi, comme l'épaisseur de la couche de copolymère à blocs varie au sein des motifs de guidage d'un même substrat (par exemple suivant leur densité), il est rare d'obtenir l'assemblage et le transfert de tous les motifs secondaires avec les mêmes performances, notamment en termes de dimension critique.

Le document US2014/021166 divulgue un procédé de formation de motifs par grapho-épitaxie, qui vise à résoudre ce problème de variation d'épaisseur entre les zones denses et les zones moins denses du guide d'assemblage. Ce procédé comporte les étapes suivantes :

- la formation d'un guide d'assemblage comprenant des motifs d'assemblage d'un premier type et des motifs d'assemblage d'un deuxième type ;
- le dépôt d'un copolymère à blocs dans les motifs d'assemblage du premier type et du deuxième type ;
- l'assemblage du copolymère à blocs ;
- le retrait d'une des phases du copolymère à blocs assemblé, obtenant ainsi des trous dans la couche de copolymère ; et
- le transfert des trous appartenant aux motifs d'assemblage du premier type dans un masque dur.

Les motifs d'assemblage du deuxième type sont des motifs « factices » (« dummy pattern ») qui ont pour seul rôle d'augmenter artificiellement le taux d'ouverture dans la zone peu dense (en motifs d'assemblage du premier type) du guide d'assemblage, afin d'obtenir une couche de copolymère à blocs de même épaisseur dans toutes les zones du substrat. Ces motifs d'assemblage factices sont dimensionnés pour que les trous correspondants ne soient pas transférés dans le substrat.

À l'instar du document US2014/021166, le document US2014/057443 cherche à éviter que la couche de copolymère à blocs ne déborde du guide dans les zones moins denses en motifs d'assemblage, ce qui générait l'assemblage du copolymère. Pour cela, les motifs d'assemblage formés dans la zone moins dense ont une hauteur supérieure à celle des motifs d'assemblage situés dans la zone dense du guide. Dans un mode de mise en oeuvre, cette différence de hauteur est obtenue par le dépôt dans la zone d'une couche de résine supplémentaire.

## RESUME DE L'INVENTION

Il existe donc un besoin de prévoir un procédé de réalisation de motifs finaux à la surface d'un substrat par auto-assemblage de copolymère à blocs qui soit indépendant de la configuration du guide d'assemblage, c'est-à-dire un procédé qui permette d'obtenir des motifs avec les mêmes performances quelle que soit la répartition et les dimensions des motifs de guidage.

Selon l'invention, on tend à satisfaire ce besoin en prévoyant les étapes suivantes :

- former un guide d'assemblage sur des première et seconde zones du substrat, le guide d'assemblage présentant par rapport à une surface de référence des ouvertures avec un taux d'ouverture dans la première zone supérieur à celui de la seconde zone ;
- déposer une couche de copolymère à blocs sur le substrat, de sorte que la couche de copolymère à blocs remplisse entièrement le guide d'assemblage et forme une surépaisseur sur la surface de référence ;
- assembler le copolymère à blocs, d'où il résulte une portion organisée de la couche de copolymère à blocs à l'intérieur des ouvertures du guide d'assemblage ;
- amincir uniformément la couche de copolymère à blocs, jusqu'à atteindre une épaisseur correspondant à la portion organisée de la couche de copolymère ;
- éliminer une des phases du copolymère à blocs assemblé, d'où il résulte une pluralité de motifs initiaux s'étendant dans la couche de copolymère à blocs ; et
- transférer les motifs initiaux de la couche de copolymère à blocs dans le substrat pour former lesdits motifs finaux.

Le guide d'assemblage peut désigner une couche (ou un empilement de plusieurs couches) dans laquelle sont formées des ouvertures, ou cavités, par exemple par photolithographie. Selon une variante de réalisation, le guide peut être réalisé sous forme d'ouvertures directement dans le substrat. Ces ouvertures forment des motifs de guidage dans lesquels est déposé le copolymère à blocs.

On appelle ci-dessus « taux d'ouverture du guide d'assemblage » le rapport entre la superficie des ouvertures dans le guide, et la surface totale d'un champ contenant ces ouvertures, par exemple de 2 $\mu$m x 2 $\mu$m. Lorsque toutes les ouvertures des motifs de guidage du substrat ont la même superficie, un taux d'ouverture dans une première zone du substrat supérieur à celui dans une seconde zone du substrat équivaut à une densité d'ouvertures plus importante dans la première zone que dans la seconde zone. On peut aussi atteindre un taux d'ouverture supérieur dans la première zone, sans nécessairement que le nombre d'ouvertures y soit plus important, lorsque les ouvertures de la première zone ont des superficies plus importantes que celles de la seconde zone.

L'étape de dépôt, appelée ci-après « étape de planarisation », permet d'obtenir une couche de copolymère à blocs, qui dépasse du guide d'assemblage (formant une surépaisseur au-dessus de la face supérieure du guide, dite surface de référence) et dont la surface est sensiblement plane.

Après l'étape d'assemblage du copolymère à blocs, une portion de la couche de copolymère à blocs située à l'intérieur des ouvertures du guide d'assemblage se retrouve organisée selon le motif recherché. En général, on cherche à obtenir des motifs orientés perpendiculairement au plan du substrat et, avantageusement, agencés de façon périodique. La portion restante de la couche de copolymère à blocs (i.e. la surépaisseur) peut être orientée ou non (i.e. désorganisée). Si elle est orientée, elle peut l'être selon la même direction que les motifs de la portion organisée ou une autre orientation. La portion restante comporte en général des défauts. Par défaut, on entend toute rupture du réseau périodique. Ces défauts sont gommés en amincissant uniformément la couche de copolymère à blocs, pour ne conserver que le copolymère correctement organisé au fond du guide.

Ainsi, grâce à l'étape de planarisation, suivie de l'étape d'assemblage et de l'étape d'amincissement, on obtient une couche de copolymère organisé de même épaisseur dans tous les motifs de guidage du substrat, quelles que soient leur taille et leur répartition dans les première et seconde zones. On peut alors retirer l'un des blocs du copolymère organisé et transférer les motifs générés par ce retrait dans le substrat de la même manière pour tous les motifs de guidage, contrairement aux procédés de l'art antérieur où il n'y a ni étape de planarisation, ni étape d'amincissement.

La portion de couche qui n'est pas située à l'intérieur des ouvertures du guide d'assemblage et organisée selon le motif recherché - dans laquelle les domaines de copolymère sont quelconques, par exemple orientés parallèlement au substrat (et non perpendiculairement) -, est sans incidence sur le transfert, puisque celle-ci est au préalable supprimée lors de l'étape d'amincissement.

L'étape d'amincissement de la couche de copolymère à blocs, réalisée par exemple par gravure plasma et/ou par polissage mécano-chimique, a lieu avantageusement après l'étape d'assemblage du copolymère. Ainsi, les blocs de monomère sont séparés et figés lors de l'étape d'amincissement de la couche. Il n'y a par conséquent aucun risque de perturber l'organisation des domaines du copolymère. L'étape d'amincissement peut néanmoins être réalisée avant l'étape d'assemblage ou encore en partie avant et en partie après.

L'étape d'amincissement et l'étape d'élimination d'une des phases du copolymère à blocs assemblé sont avantageusement réalisées dans un même bâti de gravure plasma, soit simultanément en utilisant un plasma unique choisi parmi Ar/O$_2$, C$_x$F$_y$, SF$_6$, N$_2$/H$_2$, CO/O$_2$, CO/H$_2$, CH$_4$/O$_2$, C$_x$F$_y$/O$_2$, CH$_x$F$_y$/O$_2$, C$_x$F$_y$/H$_2$, CH$_x$F$_y$/H$_2$ et C$_x$H$_y$/H$_2$, soit par une succession d'étapes utilisant des plasmas de natures différentes ou par alternance d'au moins deux plasmas.

De préférence, le dépôt de la couche de copolymère à blocs est réalisé par dépôt à la tournette.

Le procédé selon l'invention peut également présenter une ou plusieurs des caractéristiques ci-dessous, considérées individuellement ou selon toutes les combinaisons techniquement possibles :

- le guide d'assemblage est formé d'un masque disposé sur le substrat et texturé par photolithographie et/ou gravure ou réalisé directement dans le substrat par photolithographie et/ou gravure ;
- ce masque comprend une première couche carbonée en contact avec le substrat et une seconde couche anti-réflective riche en silicium disposée sur la première couche carbonée, ladite couche anti-réflective riche en silicium servant de couche d'arrêt lors de l'amincissement de la couche de copolymère à blocs assemblé ;
- le guide d'assemblage comporte une pluralité d'ouvertures formant des motifs de guidage répartis entre les première et seconde zones du substrat ;
- les motifs de guidage ont une hauteur comprise entre 5 nm et 1000 nm ;
- la surface des motifs de guidage présente une affinité particulière pour un ou plusieurs des blocs du copolymère à blocs ;
- le fond des motifs de guidage est neutre par rapport aux blocs du copolymère à blocs tandis que les flancs des motifs de guidage présentent une affinité particulière pour un ou plusieurs des blocs du copolymère à blocs ;
- la surface des motifs de guidage est neutre par rapport aux blocs du copolymère à blocs ;
- l'affinité particulière du guide d'assemblage pour un ou plusieurs blocs du copolymère à blocs est obtenue par le greffage d'un ou plusieurs homopolymères ; et
- la neutralisation du guide d'assemblage est obtenue par le greffage d'un copolymère statistique.

## BREVES DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- les figures 1A à 1G représentent par des vues de coupe des étapes d'un procédé pour réaliser des motifs à la surface d'un substrat, selon un mode de mise en oeuvre préférentiel de l'invention ;
- la figure 2 représente la variation d'épaisseur de copolymère à blocs au sein d'un guide d'assemblage en fonction de la densité des motifs dans le guide, après l'étape de dépôt selon un procédé de l'art antérieur (essai n°1) et après l'étape d'amincissement du procédé selon l'invention (essais n°2 et 3) ; et
- les figures 3A et 3B représentent schématiquement une couche de copolymère à blocs au sein d'un guide d'assemblage, respectivement après l'étape de dépôt selon un procédé de l'art antérieur et après l'étape d'amincissement du procédé selon l'invention.

Pour plus de clarté, les éléments identiques ou similaires sont repérés par des signes de références identiques sur l'ensemble des figures.

## DESCRIPTION DETAILLEE D'AU MOINS UN MODE DE REALISATION

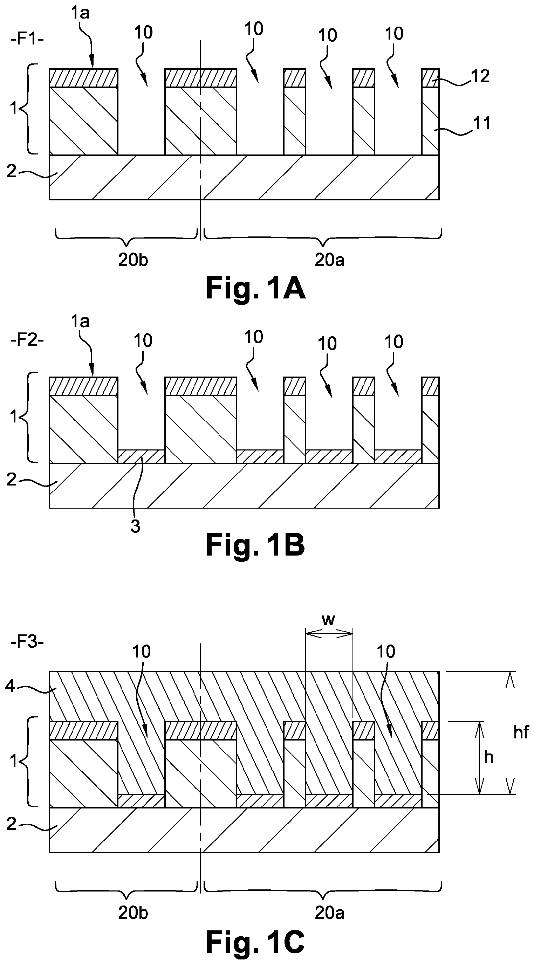

Un mode de mise en oeuvre préférentiel du procédé selon l'invention va maintenant être décrit en référence aux figures 1A à 1G.

Le procédé comporte tout d'abord une étape F1 représentée à la figure 1A pendant laquelle on forme un guide d'assemblage 1 à la surface d'un substrat 2. Le guide d'assemblage 1 comporte des ouvertures 10 qui s'étendent de la face supérieure 1a du guide jusqu'au substrat 2. Ces ouvertures 10 correspondent aux motifs de guidage dans lesquels sera déposé le copolymère à blocs.

Le substrat 2 comporte au moins deux zones 20a et 20b sur lesquelles sont répartis les motifs de guidage 10. La répartition des motifs 10 au sein du guide d'assemblage 1 est telle que le guide présente un taux d'ouverture dans la zone 20a supérieur à celui dans la zone 20b. Dans l'exemple de la figure 1A, cela est schématisé par trois ouvertures 10 dans la zone 20a, alors que la zone 20b n'en compte qu'une seule, toutes les ouvertures 10 ayant sensiblement les mêmes dimensions. Ici, on souhaite donc former trois fois plus de motifs dans la zone 20a que dans la zone 20b.

On pourrait aussi envisager une zone 20a comprenant autant d'ouvertures 10 que la zone 20b, mais des ouvertures dont les dimensions sont supérieures à celles de la zone 20b. Ce cas se présente notamment lorsqu'on souhaite former, sur un même substrat, plusieurs motifs (par exemple des trous de contact) par ouverture 10 dans la zone 20a (« contact multiplication ») et un seul motif par ouverture dans la zone 20b (« contact shrinking »).

Le guide d'assemblage 1 peut être formé d'un masque dur qui recouvre le substrat et se compose d'une ou plusieurs couches. Les motifs de guidage 10 dans le masque sont alors obtenus par gravure de ces différentes couches. Typiquement, une couche de résine est déposée sur le masque dur, puis imprimée au moyen d'une photolithographie (à une longueur d'onde de 193 nm par exemple), d'une lithographie Extrême UltraViolet (EUV), d'une lithographie par faisceau d'électrons (« e-beam ») ou toute autre technique de lithographie (nano-impression, photolithographie à exposition multiple...). Puis, les motifs de guidage imprimés dans la résine sont transférés par gravure dans les couches du masque dur.

De préférence, le masque dur est un empilement bicouche comportant une première couche carbonée 11 (« Spin On Carbon », SOC), en contact avec le substrat 2, et une seconde couche anti-réflective 12 disposée sur la couche carbonée 11. La couche anti-réflective 12 est, par exemple, un revêtement riche en silicium (« Silicon Anti-Reflective Coating », SiARC). Cet empilement bicouche permet notamment d'adapter l'indice de réfraction optique du substrat, évitant la création d'ondes stationnaires lors de l'étape de photolithographie, et présente une bonne sélectivité face à la gravure du copolymère à blocs.

Dans une variante de réalisation (non représentée), le guide d'assemblage peut être formé d'une couche de résine disposée directement sur le substrat, les motifs de guidage ayant été imprimés dans la résine au moyen de l'une quelconque des techniques de lithographie susmentionnées, par exemple par photolithographie (insolation et développement d'une partie de la résine). Cette résine peut notamment être une résine à tonalité de développement négative (« negative tone development resist » en anglais). Un solvant est alors utilisé pour enlever les régions non-exposées de la résine, tandis que les régions exposées restent sur le substrat.

Vus de dessus, les motifs de guidage 10 du guide 1 peuvent avoir différentes formes, notamment rectangulaire, circulaire ou elliptique, et des écartements ou pas de répétition (« pitch » en anglais) variables, afin d'obtenir une réduction et/ou une multiplication des trous de contact (« contact shrink » et/ou « contact multiplication »). Ils peuvent aussi former des réseaux de lignes. L'épaisseur du guide 1, c'est-à-dire la hauteur des motifs 10, est avantageusement comprise entre 5 nm et 1000 nm, typiquement entre 20 nm et 300 nm.

Dans ce mode de mise en oeuvre préférentiel, une étape de préparation de surface peut être réalisée pour favoriser la disposition des domaines du copolymère à blocs, par exemple perpendiculairement à la surface sur laquelle celui-ci sera déposé. Cette étape optionnelle F2 est représentée à la figure 1B.

Trois modes de préparation peuvent être envisagés pour obtenir trois types de configuration :

- l'ensemble de la surface des cavités 10 présente une affinité particulière pour l'un ou plusieurs des blocs du copolymère ;
- les flancs des cavités 10 présentent une affinité particulière pour un ou plusieurs des blocs du copolymère et le fond des cavités 10 est neutre par rapport aux blocs du copolymère ;
- l'ensemble de la surface des cavités 10 est neutre par rapport aux blocs du copolymère.

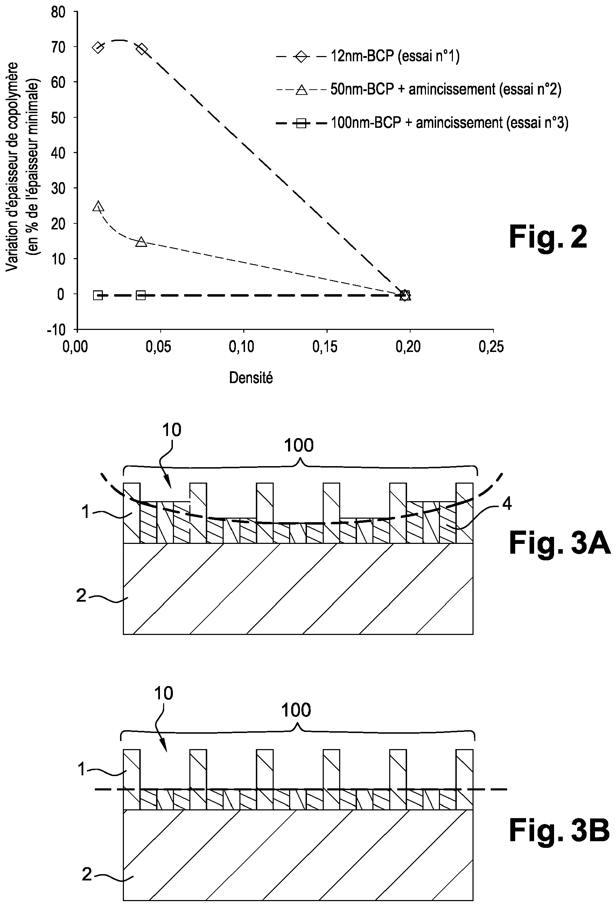

Pour qu'une surface présente une affinité particulière vis-à-vis d'un ou plusieurs blocs de copolymère, on peut y greffer un ou plusieurs homopolymères adaptés. La neutralisation de surface peut quant à elle être obtenue en greffant un copolymère statistique. Comme cela est visible sur la figure 2, une couche 3 en homopolymère ou en copolymère statistique est alors greffée sur le fond et/ou les parois latérales des motifs de guidage 10. La couche greffée 3 a typiquement une épaisseur de 2 nm à 20 nm. Le greffage de la couche 3 s'effectue classiquement en trois étapes : dépôt du matériau (homopolymère ou copolymère statistique), recuit et rinçage.

D'autres façons de neutraliser le substrat peuvent être envisagées, notamment par traitement plasma, traitement UV, implantation ionique ou dépôt d'une monocouche auto-assemblée (SAM, « Self-Assembled Monolayer »). Le substrat peut également être choisi de sorte à favoriser la disposition des domaines de copolymère. Il n'est donc pas obligatoire de faire appel à une couche de neutralisation.

A l'étape F3 de la figure 1C, une couche de copolymère à blocs 4 est déposée dans le guide d'assemblage 1. La différence de taux d'ouverture du guide d'assemblage dans plusieurs zones du substrat occasionne, dans le procédé de l'art antérieur, une différence d'épaisseur de la couche de copolymère à l'intérieur du guide. A l'inverse, dans le procédé des figures 1A à 1F, les conditions du dépôt sont choisies pour que la couche de copolymère à blocs 4 ait, dans chaque zone 20a, 20b du substrat, sensiblement la même épaisseur. Cela requiert que la couche 4 dépasse du guide d'assemblage 1. Ainsi, les motifs de guidage 10 sont non seulement entièrement remplis, mais en outre, la couche de copolymère à blocs 4 est en surépaisseur au-dessus du guide 1.

Or, dans les procédés classiques d'auto-assemblage DSA, on évite de déposer une couche de trop forte épaisseur car, comme il sera décrit plus loin, l'assemblage d'un copolymère à blocs en dehors d'un guide provoque des défauts d'orientation.

Le copolymère à blocs de la couche 4 peut être un copolymère di-blocs (deux monomères A et B) ou multi-bloc (plus de deux monomères), un mélange de polymères, un mélange de copolymères ou encore le mélange d'un copolymère et d'un homopolymère. Il peut être de morphologie quelconque, par exemple sphérique, cylindrique, gyroïde, lamellaire..., selon la proportion entre les blocs de monomère.

Le matériau de la couche 4 est, par exemple, un copolymère di-bloc contenant un dérivé styrènique (typiquement du polystyrène, PS) et un dérivé de méthalcrylate (typiquement du polyméthacrylate de méthyle, PMMA). Avec 30% en poids de PMMA et 70 % en poids de PS, les domaines de PMMA sont, après assemblage, en forme de cylindres contenus dans une matrice de PS. Bien sûr, d'autres proportions entre les monomères peuvent être envisagées, afin d'obtenir des domaines de géométrie différente (lamellaire, sphérique...).

Le dépôt de la couche de copolymère à blocs est, de préférence, réalisé par dépôt à la tournette (ou « spin coating » selon le terme anglais). Une solution contenant un solvant (par exemple du toluène ou de l'éther monométhylique de propylène glycol (PGMEA)) et le matériau copolymère (par exemple PS-*b*-PMMA) est étalée sur le substrat, par force centrifuge. Ce mode de dépôt est particulièrement adapté pour aplanir une topographie de surface, comme celle générée par les cavités du guide d'assemblage 1 sur le substrat 2.

La planarisation d'une topographie de surface par dépôt à la tournette a fait l'objet de nombreuses études. En particulier, dans l'article ["Planarization of Substrate Topography by Spin Coating", J. Electrochem. Soc. 1987 volume 134, issue 8, 2030-2037], L. E. Stillwagon et al. ont mis en évidence que l'efficacité de cette planarisation dépend des dimensions de la cavité à remplir (cf. Fig.1C, largeur w et hauteur h), de l'épaisseur ($h_f$) du film de polymère déposé et de la viscosité du polymère. Selon L. E. Stillwagon et al., la surface devient plane lorsque les forces de capillarité sont égales à la force centrifuge durant le fonctionnement de la tournette. Il peut être ainsi défini une largeur critique de cavité $w_c$ en dessous de laquelle la surface de polymère est plane immédiatement après le dépôt à la tournette. Cette largeur critique s'écrit :

$$w_c = \left(\frac{16\gamma h}{\rho\omega^2 r}\right)^{\frac{1}{3}} \qquad (1)$$

où y est la tension de surface, h est la hauteur de la cavité, $\rho$ la densité du polymère, $\omega$ la vitesse de rotation du substrat et r la position radiale de la cavité sur le substrat.

Ainsi, toutes les cavités ayant une largeur inférieure à la largueur critique $w_c$ peuvent être aplanies par le dépôt à la tournette. On peut en conclure qu'une cavité étroite (w faible) est plus facile à aplanir qu'une cavité large (w important). Par ailleurs, un champ de motifs 10 dense peut être considéré pendant le dépôt à la tournette comme une cavité unique et large. Dans l'exemple de guide d'assemblage de la figure 1C, les trois motifs 10 de la zone 20a sont suffisamment rapprochés pour être vus comme une seule cavité de dimensions trois fois plus grandes que le motif 10 de la zone 20b. Il est donc plus facile d'aplanir des contacts isolés, tels que le motif 10 de la zone 20b, qu'un champ de motifs dense (zone 20a).

L'équation (1) ci-dessus ne prend pas en compte la viscosité du matériau polymère, car elle se fonde sur l'hypothèse que le matériau déposé à la tournette est un fluide newtonien, c'est-à-dire un fluide pour lequel la viscosité ne varie ni avec la vitesse de déformation, ni avec le temps. D'après L. E. Stillwagon et al., une deuxième équation peut alors être introduite pour prendre en compte le fait que la réponse d'un matériau polymère soumis à une force peut s'étaler dans le temps. Cette équation définit le temps $t_p$ nécessaire pour remplir complètement la cavité avec un matériau polymère visqueux après l'arrêt de la tournette et s'écrit :

$$ t_p = \frac{3}{32} \frac{\omega^4 \, \eta}{\gamma \, \mathrm{h}_f^3} \qquad (2) $$

où $\omega$ est la vitesse de rotation du substrat, $\eta$ la viscosité du polymère, $\gamma$ la tension de surface et $h_f$ l'épaisseur du film de polymère déposé sur le substrat.

On constate que plus le matériau polymère est visqueux ($\eta$ élevé), plus le temps d'attente $t_p$ est grand. En outre, le temps d'attente $t_p$ augmente lorsque l'épaisseur de la couche déposée diminue. Il est donc difficile d'obtenir une fine couche plane avec un matériau fortement visqueux par dépôt à la tournette.

Grâce aux enseignements de cet article, et compte tenu de l'application envisagée ici, il est possible de former une couche de copolymère à blocs 4 d'épaisseur sensiblement identique sur toutes les zones du substrat, y compris les zones 20a et 20b ayant des taux d'ouverture différents. La viscosité de la solution contenant le copolymère à blocs est en effet faible (proche de celle du solvant de dissolution), par exemple inférieure à 1.3 cP. En outre, les épaisseurs de la couche 4 déposée à l'étape F3 sont bien plus importantes que dans le procédé de l'art antérieur (car on dépasse le guide 1), de sorte que la couche plane 4 peut être obtenue quasiment instantanément après l'arrêt de la tournette.

L'épaisseur de la couche de copolymère 4 déposée sur le substrat 2 est avantageusement comprise entre 1 fois et 2 fois l'épaisseur du guide d'assemblage 1. Les conditions du dépôt, telles que la vitesse de rotation, le pourcentage massique de copolymère à blocs dans la solution de dépôt et la durée de rotation, pourront être déterminées empiriquement, car la quantité de copolymère nécessaire pour remplir entièrement le guide dépend évidemment du nombre et de la taille des motifs de guidage 10 formés sur le substrat, en particulier de leur hauteur. Diverses techniques de caractérisation morphologique, comme le profilomètre, permettent de vérifier que la couche 4 est plane en surface, synonyme que tous les motifs de guidage 10 sont remplis. Plusieurs exemples de ces conditions de dépôt seront donnés par la suite.

Le taux de planarisation obtenu en fonction de l'épaisseur de copolymère à blocs déposée a été étudié, notamment dans l'article [« A Parametric Study of Spin Coating over Topography », Ind. Eng. Chem. Res., Vol. 37, No. 6, pp. 2223-2227, 1998]. Pour l'étape F3 de la figure 1C, la planéité de la couche de copolymère à blocs 4 est jugée satisfaisante lorsque le taux de planarisation (tel que défini dans cet article) est supérieur à 50%, et avantageusement supérieur à 75%.

Les conditions pour obtenir et contrôler l'épaisseur déposée sont déterminables à partir de lois expérimentales donnant :

- l'épaisseur d'un film en polymère en fonction de la vitesse de rotation, pour une viscosité donnée ;
- l'épaisseur du film en fonction de la concentration en polymère dans la solution de dépôt ; et
- la viscosité en fonction de la concentration en polymère dans la solution.

Ces lois peuvent être tirées de l'article [« Characteristics of resist films produced by spinning », J. Appl. Phys., Vol. 49, No.7, July 1978].

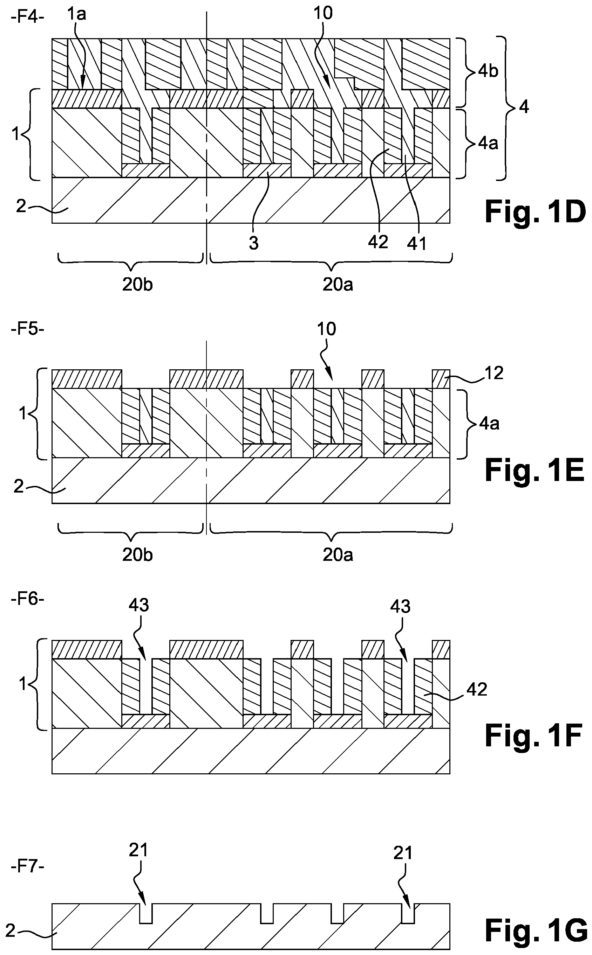

La figure 1D représente l'étape d'assemblage F4 du copolymère à blocs, après le dépôt de la couche 4 à l'étape F3. Après assemblage, on distingue deux portions de la couche de copolymère : une portion 4a située au fond du guide d'assemblage 1 et une portion 4b située sur la portion 4a et correspondant sensiblement à la surépaisseur de la couche de copolymère 4 au-dessus du guide d'assemblage 1.

Dans la portion 4b, les domaines du copolymère (ici du PS-b-PMMA) sont généralement mal orientés. Les domaines de PMMA et de PS peuvent s'agencer de façon aléatoire. On observe par exemple des défauts en surface de type orientation mixte, c'est-à-dire un mélange de cylindres de PMMA orientés parallèlement et perpendiculairement au substrat 2.

Par contre, de façon surprenante, dans la portion 4a, les domaines du bloc PMMA et du bloc PS sont correctement orientés. Avec l'exemple de copolymère mentionné plus haut, les domaines de PMMA sont en forme de cylindres 41 perpendiculaires au substrat 2, chaque cylindre 41 étant entouré d'une matrice 42 de polystyrène.

Comme c'est le cas sur la figure 1D, la face supérieure de la portion organisée 4a peut ne pas correspondre à la surface du guide d'assemblage 1 (surface de référence 1a). Par exemple, pour un guide d'assemblage 1 formé d'un empilement SiARC/SOC de 125 nm d'épaisseur, la portion organisée 4a de la couche de copolymère PS-b-PMMA atteindra 70 nm d'épaisseur.

L'auto-assemblage des blocs est, de préférence, réalisé au moyen d'un traitement thermique ou recuit. La température et la durée du recuit sont avantageusement optimisées en fonction de l'épaisseur de la couche de copolymère 4. Plus la couche 4 est épaisse, plus la durée et/ou la température du recuit est importante. Par exemple, pour une épaisseur de couche d'environ 50 nm, un recuit de 2 min à 250 °C peut être réalisé dans le cas d'un copolymère PS-b-PMMA de période de 35 nm environ. L'assemblage du copolymère à blocs peut alternativement être obtenu par un traitement par ultrasons ou par une opération dite d'évaporation de solvant (« solvent annealing »), plutôt que par un traitement thermique, ou encore par une combinaison de ces deux techniques, ou bien par toute autre technique connue de l'homme du métier.

L'étape F5 de la figure 1E consiste à graver la portion 4b de la couche de copolymère située à la surface du guide d'assemblage 1, jusqu'à atteindre la portion organisée 4a située à l'intérieur du guide 1. Cette gravure est réalisée de façon directionnelle et uniforme sur la plaque de sorte que la couche de copolymère ainsi amincie ait la même épaisseur en tout point du substrat 2, et donc dans les zones 20a et 20b où la répartition et/ou les dimensions des motifs de guidage 10 diffèrent. Par exemple, on peut effectuer une gravure anisotrope.

Dans un mode de mise en oeuvre de l'étape F5, l'amincissement de la couche de copolymère à blocs 4 est réalisé par polissage mécano-chimique (CMP, pour « Chemical Mechanical Planarization » en anglais).

Dans une variante de mise en oeuvre, l'amincissement de la couche de copolymère 4 est réalisé par gravure plasma. La couche de SiARC 12 peut servir avantageusement de couche d'arrêt de la gravure. Elle permet alors de mieux contrôler l'amincissement et évite la détérioration des motifs de guidage 10. Dans le cas d'une intégration où le guide ne permet pas d'être utilisé comme couche d'arrêt (exemple du guide en résine), il est possible de créer cette couche d'arrêt avant le dépôt du copolymère à blocs, par exemple en densifiant la résine constituant le guide ou en déposant un oxyde sur le guide. Le dépôt de l'oxyde peut se faire par différentes techniques de dépôt (PECVD, ALD, PEALD...) afin d'être compatible avec le matériau constituant le guide en termes de température de dépôt. A titre d'exemple, une couche de dioxyde de silicium $SiO_2$ peut être déposée sur le guide en résine par PEALD (« Plasma-Enhanced Atomic Layer Déposition ») à une température de 50 °C ou la résine du guide peut être densifiée pendant 50 secondes par un plasma HBr (100 sccm) sous une pression de 5 mTorr et avec une puissance de 1200 W. L'oxyde est un matériau facilement intégrable mais il peut être remplacé par tout autre matériau remplissant le rôle de couche d'arrêt lors de l'amincissement du polymère et dont le dépôt est compatible avec le guide.

Les gaz pouvant être utilisés pour graver les copolymères à blocs sont, par exemple, $O_2$, CO, $CO_2$, $H_2$, $N_2$... . Ces gaz peuvent être combinés entre eux (ex. $CO/O_2$, $CO/H_2$...) ou avec d'autres gaz inertes (ex. $Ar/O_2$, $Ar/N_2$, $He/O_2$...), polymérisants (i.e. carbonés, ex. $CH_4/O_2$) ou fluorés ($C_xF_y/O_2$, $CH_xF_y/O_2$, $C_xF_y/H_2$, $CH_xF_y/H_2$...). Un mélange de plusieurs types de gaz peut également être utilisé, ainsi que d'autres chimies de gaz : $C_xF_y$, $SF_6$...

A titre d'exemple, le plasma est généré à partir d'un mélange de gaz $Ar/O_2$, sous une pression de 10 mTorr, avec une puissance de 220 W et une tension de polarisation de 100 V. La quantité d'oxygène représente entre 9 % et 100 % du mélange. On peut ainsi graver le copolymère PS-b-PMMA de façon sélective par rapport au SiARC (une sélectivité supérieure à 20, par exemple de l'ordre de 40, peut ainsi être atteinte).

Contrairement au polissage mécano-chimique, la gravure par plasma présente l'avantage de graver le copolymère sans détériorer le guide d'assemblage 1. En effet, compte tenu que la portion organisée 4a du copolymère à blocs se trouve à l'intérieur du guide 1, le polissage mécano-chimique a pour effet de raboter le guide en même temps que le copolymère à blocs pour atteindre l'épaisseur souhaitée, par exemple 70 nm dans un guide de 125 nm de hauteur. A l'inverse, un procédé de gravure par plasma peut laisser intact le guide d'assemblage, du fait de sa grande sélectivité par rapport au(x) matériau(x) qui constitue(nt) le guide d'assemblage.

Enfin, dans une autre variante de mise en oeuvre, l'amincissement de la couche de copolymère est réalisé par voie humide, assistée ou non d'une exposition aux ultraviolets. Les solutions liquides permettant de graver les copolymères à blocs sont des solvants, comme le PGMEA, le toluène et le cyclohexane. La solution choisie ne grave pas le guide d'assemblage. Afin de contrôler au mieux l'amincissement et l'épaisseur de copolymère à blocs restant dans le guide, la surface de la couche de copolymère peut être préalablement modifiée par un plasma en utilisant un gaz comme He, Ar, HBr, $N_2$, $CH_4$, CO, $H_2$, $C_xF_y$, $C_xH_y$, $CH_xF_y$ ... ou une combinaison de plusieurs de ces gaz (ex. $Ar/H_2$, $He/CH_4$). La partie ainsi modifiée par plasma est ensuite retirée sélectivement par voie humide laissant dans le guide uniquement la partie non modifiée. Par exemple, le plasma de modification chimique est généré à partir du gaz Ar sous une pression de 10 mTorr, avec une puissance de 500 W et une tension de polarisation de 300 V.

Toujours dans un souci de contrôler au mieux l'amincissement et l'épaisseur de copolymère à blocs restant dans le guide, plusieurs étapes de gravure plasma et gravure humide peuvent alterner afin d'avoir une gravure précise de la couche de copolymère. Cette approche reprend le principe des nouvelles techniques de gravures ALE (« Atomic Layer Etching » en anglais), qui reposent sur des cycles de gravure plasma/dépôt ou des cycles de gravure plasma/humide, sur l'utilisation de gaz pulsé ou sur l'utilisation d'une tension RF lors de la gravure plasma. Toutes ces techniques peuvent être utilisées durant les étapes d'amincissement afin d'avoir un meilleur contrôle de l'épaisseur gravée de copolymère à blocs et de celle restante dans le guide.

Il est préférable, en cas d'amincissement par gravure plasma notamment, de réaliser l'assemblage du copolymère à blocs avant l'amincissement de la couche 4, et non pas après, car l'amincissement pourrait altérer une des deux phases du copolymère, de sorte qu'il devienne difficile de séparer ces deux phases.

Le procédé comporte ensuite une étape F6 (cf. Fig.1F) d'élimination d'une des phases de la couche de copolymère à bloc assemblé, ici les cylindres de PMMA 41. Pour cela, on peut notamment plonger la portion restante 4a de la couche de copolymère à blocs dans de l'acide acétique concentré à 99% pendant 10 minutes. Une exposition UV préalable peut également être réalisée.

Des motifs 43 sont alors obtenus dans une couche résiduelle 42 composée uniquement de l'autre phase du copolymère, le polystyrène. La résolution de ces motifs secondaires 43 est très élevée, car du même ordre de grandeur que les domaines de PMMA.

De préférence, le retrait des cylindres de PMMA (étape F6) est réalisé dans le même bâti de gravure plasma que l'amincissement de la couche de copolymère (étape F5).

Une première stratégie consiste à réaliser les deux étapes simultanément, en utilisant un seul plasma avec des mélanges de gaz (gaz réactif/inerte ou gaz réactif/polymérisant) tels que Ar/O$_2$, C$_x$F$_y$, SF$_6$, N$_2$/H$_2$, CO/O$_2$, CO/H$_2$, CH$_4$/O$_2$, C$_x$F$_y$/O$_2$, CH$_x$F$_y$/O$_2$, C$_x$F$_y$/H$_2$, CH$_x$F$_y$/H$_2$ et C$_x$H$_y$/H$_2$. Pour pouvoir réaliser avec le même plasma ces deux étapes, la sélectivité entre le polystyrène et le PMMA durant cette gravure sera avantageusement comprise entre 1 et 5.

Une deuxième stratégie consiste à réaliser plusieurs étapes de gravure successives au sein d'un même équipement, pour d'abord amincir la couche de copolymère à blocs, puis retirer le PMMA sélectivement par rapport au PS, avec des chimies de gravure différentes entre les deux étapes. A titre d'exemple, on peut réaliser l'amincissement grâce à un plasma CF$_4$ (pas de sélectivité entre PMMA et PS) puis retirer le PMMA grâce à un plasma CO/O$_2$ (sélectivité PMMA/PS > 10), ce qui permet contrôler indépendamment l'amincissement et le retrait du PMMA par gravure plasma. On peut aussi procéder par alternance d'au moins deux plasmas pour encore améliorer ce contrôle, c'est-à-dire en réalisant des cycles de gravure successifs (par exemple Ar, Ar/O$_2$, Ar... ou CF$_4$, CO/H$_2$, CF$_4$... ou CO, CO/H$_2$, CO...).

Bien que cette approche soit moins avantageuse, les deux étapes F5 et F6 peuvent faire appel à deux équipements différents. L'amincissement de la couche de copolymère peut être réalisé avec un plasma sans sélectivité vis à vis du SiARC, du PMMA ou du PS, en utilisant notamment des chimies fluorés (ex. CF$_4$), tandis que le retrait du PMMA est réalisé par d'autres voies que la gravure plasma, par exemple par voie humide.

Enfin, à l'étape F7 de la figure 1G, les motifs 43 dans la couche de polystyrène 42 sont transférés dans le substrat 2 sous-jacent. On obtient alors à la surface du substrat 2 les motifs souhaités 21 (trous de contact pour former des via, tranchées pour former des lignes de métal...). Ce transfert utilise la couche de polystyrène 42 et le guide d'assemblage 1 comme masque de gravure. Autrement dit, seules les portions du substrat 2 situées à l'aplomb des trous 43 sont gravées. On élimine ensuite le polystyrène 42 et le guide d'assemblage 1 pour ne conserver que le substrat 2 gravé au niveau des ouvertures du guide.

Des essais ont été réalisés sur un substrat muni d'un guide d'assemblage ayant une hauteur d'environ 125 nm et un taux d'ouverture variable. Les motifs de guidage considérés sont des cylindres de taille unique. Le taux d'ouverture, qui équivaut donc ici à une densité

de motifs ( $densité = \dfrac{\pi}{4}\left(\dfrac{CD}{d}\right)^2$, où CD est le diamètre des cylindres et d est la distance entre deux cylindres consécutifs) est égal à 0.01, 0.04 ou 0.2 selon la zone du substrat (soit respectivement 1, 4 ou 16 motifs de guidage répartis sur un même champ de 2 μm x 2 μm).

Pour ces essais, différentes conditions de dépôt du copolymère par « spin-coating » ont été envisagées :

- conditions de l'essai n°1 : vitesse de rotation d'environ 2000 tours/min, 0.5 % en poids de copolymère dans la solution de dépôt et temps de rotation d'environ 20 s;
- conditions de l'essai n°2 : vitesse de rotation d'environ 1000 tours/min, 1.5 % en poids de copolymère dans la solution de dépôt et temps de rotation d'environ 20 s; et
- conditions de l'essai n°3 : vitesse de rotation d'environ 1000 tours/min, 3 % en poids de copolymère dans la solution de dépôt et temps de rotation d'environ 20 s

A titre de comparaison, le même copolymère a été étalé avec les mêmes conditions de dépôt sur des substrats « témoins » sans motifs de guidage, pour déterminer l'épaisseur équivalente de copolymère sur une surface sans topographie.

Dans les conditions de l'essai n°1, l'épaisseur équivalente de la couche de copolymère (mesurable sur le substrat témoin, par exemple par ellipsométrie) est d'environ 12 nm. Sur le substrat avec le guide d'assemblage, on observe au microscope électronique à balayage que certains motifs de guidage ne sont pas entièrement remplis par le matériau copolymère. La quantité déposée de copolymère est donc insuffisante et une couche plane n'est pas atteinte.

Ce premier essai reflète des conditions d'obtention de motifs selon le procédé de l'art antérieur (où il n'y a ni étape de planarisation, ni étape d'amincissement). Les valeurs d'épaisseur obtenues dans le guide après assemblage diffèrent selon la densité des motifs de guidage : typiquement 120 nm pour une densité de motifs de 0.01, 120 nm pour une densité de 0.04 et 50 nm pour une densité de 0.2 (mesures AFM).

Dans les conditions de l'essai n°2, l'épaisseur équivalente de la couche de copolymère est d'environ 50 nm et tous les motifs de guidage sont entièrement recouverts par le copolymère à blocs. Une étape d'amincissement, par plasma Ar/O$_2$, succède au dépôt à la tournette et à l'assemblage du copolymère. Elle comporte une première étape de gravure d'environ 20 s pour atteindre la surface du guide (i.e. la couche de SiARC) puis une seconde étape, dite de sur-gravure, d'environ 5 s pour atteindre la portion organisée de la couche de copolymère.

Après assemblage et amincissement, la couche de copolymère à blocs assemblé dans le guide mesure 110 nm d'épaisseur où la densité des motifs de guidage est égale à 0.01, 100 nm d'épaisseur où la densité vaut 0.04 et 85 nm d'épaisseur où la densité vaut 0.2 (mesures AFM).

Enfin, dans les conditions de l'essai n°3, l'épaisseur équivalente de la couche de copolymère est d'environ 120 nm. Tous les motifs sont également enterrés par le matériau copolymère à blocs. L'opération d'amincissement qui suit l'assemblage est identique à celle décrite dans l'essai n°2, sauf en ce qui concerne la durée des deux étapes de gravure : environ 46 s pour la première étape et 12 s pour la seconde étape de sur-gravure. On constate sur les images AFM, qu'après assemblage et amincissement, l'épaisseur de la couche de copolymère à blocs est identique dans toutes les zones du guide d'assemblage, c'est-à-dire quelle que soit la densité des motifs de guidage. Elle vaut approximativement 70 nm.

La figure 2 est un graphique regroupant les résultats des essais ci-dessus. Il montre la variation d'épaisseur du copolymère à blocs à l'intérieur du guide d'assemblage (en pourcentage de la plus faible épaisseur obtenue, i.e. dans les motifs les plus denses - densité = 0.2), selon la densité des motifs de guidage. La courbe supérieure correspond à l'essai n°1, c'est-à-dire à des conditions classiques de dépôt à la tournette (sans planarisation). Les deux autres courbes correspondent aux essais n°2 et n°3, qui mettent en oeuvre les étapes des figures 1C et 1E (planarisation et amincissement).

On constate sur ce graphique que le procédé selon l'invention permet d'atténuer de façon significative la variation d'épaisseur au sein d'un guide d'assemblage de densité variable. En effet, en déposant l'équivalent d'une couche de 50 nm d'épaisseur, la variation d'épaisseur au sein du guide atteint seulement 30 % (courbe du milieu), contre 70 % dans le procédé de l'art antérieur (courbe du haut). En déposant l'équivalent d'une couche de 120 nm d'épaisseur, une épaisseur uniforme i.e. une variation nulle) peut être atteinte. Cette homogénéité d'épaisseur, obtenue grâce à la combinaison des étapes de planarisation et d'amincissement, permettra de transférer par gravure aussi bien des trous de contact denses que des trous de contact isolés, avec un minimum de défauts (contacts manquants ou sur-gravés).

L'écart entre la courbe d'épaisseur équivalente 50 nm et la courbe d'épaisseur équivalente 120 nm s'explique par le fait qu'une meilleure planéité est obtenue dans le deuxième cas (épaisseur plus importante ; cf. équation n°2). Néanmoins, comme discuté précédemment, on constate déjà une nette amélioration dans l'épaisseur finale du copolymère assemblé (et donc dans le transfert ultérieur des motifs) à partir de 50 nm. Par conséquent, les conditions du dépôt pourront être choisies pour déposer une couche de copolymère à blocs ayant une épaisseur équivalente supérieure à 50 nm et, de préférence, supérieure à 120 nm.

Comme cela est illustré sur la figure 3A, le procédé de réalisation de motifs selon l'art antérieur occasionne, après le dépôt à la tournette, une épaisseur de copolymère plus importante sur les bords d'un champ de motifs 100 qu'au centre de ce même champ, car il existe localement une rupture de la densité des motifs de guidage 10 (cette densité tombe subitement à zéro au-delà du champ 100). Or, cette différence d'épaisseur provoque habituellement l'apparition de motifs indésirables en bord de champ 100. A l'inverse, sur la figure 3B, l'épaisseur obtenue après l'étape d'amincissement de la figure 1E est uniforme, aussi bien au centre du champ de motifs 100 que sur ses bords. Le procédé selon l'invention présente donc l'avantage d'être dépourvu de cet effet ce bord.

Naturellement, le procédé de réalisation de motifs selon l'invention n'est pas limité au mode de réalisation qui vient d'être décrit en référence aux figures 1A à 1G et de nombreuses variantes peuvent être envisagées.

Par exemple, l'étalement de la couche de copolymère à blocs à l'étape F3 (Fig.1C) peut être obtenu autrement que par dépôt à la tournette, par exemple par dépôt en phase vapeur (CVD) ou toute autre technique connue de l'homme du métier.

Bien que cette solution soit moins avantageuse, il est possible de réaliser l'amincissement de la couche de copolymère à blocs avant que celui-ci ne soit assemblé. On réduit dans ce cas l'épaisseur de la couche de copolymère à blocs jusqu'à atteindre une épaisseur qui correspond à la future portion organisée du copolymère à blocs. Des essais préalables auront permis de déterminer en dessous de quelle hauteur se situe la portion organisée de copolymère, et donc jusqu'où amincir la couche de copolymère.

On peut aussi prévoir l'amincissement en deux étapes, successives ou séparées chronologiquement par l'étape d'assemblage du copolymère à blocs. Autrement dit, la première de ces étapes peut être réalisée avant assemblage du copolymère à blocs et la deuxième étape après l'assemblage. On utilisera par exemple une technique de gravure agressive lors de la première étape, afin de « dégrossir » la couche de copolymère, et une technique de gravure moins agressive pour la deuxième étape, afin d'obtenir une couche de copolymère amincie avec un meilleur état de surface (i.e. plus lisse). Par ailleurs, les différents modes d'amincissement décrits plus haut (CMP, gravure plasma, gravure humide) peuvent être combinés, par exemple CMP pour la première étape et gravure plasma pour la deuxième étape.

En outre, d'autres matériaux que ceux cités précédemment peuvent être utilisées, notamment pour la couche de copolymère à blocs, par exemple PS-b-PLA : polystyrène-block-acide polylactique, PS-b-PEO: polystyrène-block-polyoxyde d'éthylène, PS-b-PDMS : polystyrène-block-polydiméthylsiloxane, PS-b-PMMA-b-PEO : polystyrène-block-polyméthylméthacrylate-block-polyoxyde d'éthylène, PS-b-P2VP : polystyrène-block-poly(2vinylpyridine). De même, le masque dur dans lequel est formé le guide d'assemblage peut être en nitrure de titane (TiN), en nitrure de silicium (SiN) et/ou en dioxyde de silicium ($SiO_2$), plutôt qu'un empilement SiARC/SOC. Le nombre et l'épaisseur des couches de masque dur sont également susceptibles de varier, selon la nature du copolymère à blocs et les techniques de gravure utilisées. Par ailleurs, une intégration du copolymère à blocs directement dans un masque en résine peut également être envisagée.

Enfin, les étapes de planarisation et d'amincissement décrites ci-dessus peuvent être employées dans une intégration hybride mêlant grapho-épitaxie et chémo-épitaxie, dans la mesure où le substrat présente une topographie - même très faible (supérieure à 5 nm) - permettant l'assemblage du copolymère à blocs.

## Revendications

1. Procédé de réalisation de motifs finaux (21) à la surface d'un substrat (2) par auto-assemblage d'un copolymère à blocs, comprenant les étapes suivantes :

   - former (F1) un guide d'assemblage (1) sur des première et seconde zones (20a, 20b) du substrat, le guide d'assemblage comprenant une couche dans laquelle sont formées des ouvertures et présentant un taux d'ouverture dans la première zone (20a) supérieur à celui de la seconde zone (20b) ;
   - déposer (F3) une couche de copolymère à blocs (4) sur le substrat (2), de sorte que la couche de copolymère à blocs (4) remplisse entièrement les ouvertures du guide d'assemblage (1) et forme une surépaisseur sur le guide d'assemblage ;
   - assembler (F4) le copolymère à blocs, d'où il résulte une portion (4a) de la couche de copolymère à blocs située à l'intérieur des ouvertures (10) du guide d'assemblage (1) et organisée selon un motif recherché ;
   - amincir (F5) uniformément la couche de copolymère à blocs (4), jusqu'à atteindre une épaisseur correspondant à la portion organisée (4a) de la couche de copolymère à blocs ;
   - éliminer (F6) une des phases (41) du copolymère à blocs assemblé, d'où il résulte une pluralité de motifs initiaux (43) s'étendant dans la couche de copolymère à blocs (42) ; et
   - transférer (F7) les motifs initiaux (43) de la couche de copolymère à blocs (42) dans le substrat (2) pour former lesdits motifs finaux (21).

2. Procédé selon la revendication 1, dans lequel le dépôt (F3) de la couche de copolymère à blocs (4) est réalisé par dépôt à la tournette.

3. Procédé selon l'une des revendications 1 et 2, dans lequel le copolymère à blocs contient au moins un dérivé styrènique et un dérivé de méthacrylate.

4. Procédé selon l'une quelconque des revendications 1 à 3, dans lequel l'amincissement (F5) de la couche de copolymère à blocs (4) est réalisé par gravure plasma.

5. Procédé selon la revendication 4, dans lequel l'amincissement (F5) de la couche de copolymère à blocs (4) et l'élimination (F6) d'une des phases (41) du copolymère à blocs assemblé sont réalisés dans un même bâti de gravure plasma.

6. Procédé selon la revendication 5, dans lequel l'amincissement (F5) de la couche de copolymère à blocs (4) et l'élimination (F6) d'une des phases (41) du copolymère à blocs assemblé sont réalisés simultanément en utilisant un plasma unique choisi parmi $Ar/O_2$, $SF_6$, $C_xF_y$, $N_2/H_2$, $CO/O_2$, $CO/H_2$, $CH_4/O_2$, $C_xF_y/O_2$, $CH_xF_y/O_2$, $C_xF_y/H_2$, $CH_xF_y/H_2$ et $C_xH_y/H_2$.

7. Procédé selon la revendication 5, dans lequel l'amincissement (F5) de la couche de copolymère à blocs (4) et l'élimination (F6) d'une des phases (41) du copolymère à blocs assemblé sont réalisés par une succession d'étapes utilisant des plasmas de natures différentes ou par alternance d'au moins deux plasmas.

8. Procédé selon l'une quelconque des revendications 1 à 7, dans lequel l'amincissement (F5) de la couche de copolymère (4) est réalisé par polissage mécanochimique.

9. Procédé selon l'une quelconque des revendications 1 à 8, dans lequel le guide d'assemblage (1) est formé d'un masque disposé sur le substrat (2) et texturé par photolithographie et/ou gravure.

10. Procédé selon la revendication 9, dans lequel le masque (1) comprend une première couche carbonée (11) en contact avec le substrat (2) et une seconde couche anti-réflective riche en silicium (12) disposée sur la première couche carbonée (11), ladite couche anti-réflective riche en silicium (12) servant de couche d'arrêt lors de l'amincissement (F5) de la couche de copolymère à blocs assemblé.

11. Procédé selon l'une quelconque des revendications 1 à 10, dans lequel le guide d'assemblage (1) comporte une pluralité d'ouvertures formant des motifs de guidage (10) répartis entre les première et seconde zones (20a, 20b) du substrat (2).

12. Procédé selon la revendication 11, dans lequel les motifs de guidage (10) ont une hauteur comprise entre 5 nm et 1000 nm.

13. Procédé selon l'une des revendications 11 et 12, dans lequel la surface des motifs de guidage (10) présente une affinité particulière pour un ou plusieurs des blocs du copolymère à blocs.

14. Procédé selon l'une des revendications 11 et 12, dans lequel le fond des motifs de guidage (10) est neutre par rapport aux blocs du copolymère à blocs, et dans lequel les flancs des motifs de guidage (10) présentent une affinité particulière pour un ou plusieurs des blocs du copolymère à blocs.

15. Procédé selon l'une des revendications 11 et 12, dans lequel la surface des motifs de guidage (10) est neutre par rapport aux blocs du copolymère à blocs.

16. Procédé selon l'une des revendications 13 et 14, dans lequel l'affinité particulière du guide d'assemblage (1) pour un ou plusieurs blocs du copolymère à blocs est obtenue par le greffage d'un ou plusieurs homopolymères.

17. Procédé selon l'une des revendications 14 et 15, dans lequel la neutralisation du guide d'assemblage (1) est obtenue par le greffage d'un copolymère statistique.

**Patentansprüche**

1. Realisierungsverfahren von endgültigen Motiven (21) an der Oberfläche eines Substrats (2) durch Selbstassemblierung eines Block-Kopolymers, umfassend die folgenden Schritte:

- Bilden (F1) eine Führungsanordnung (1) auf dem ersten und zweiten Bereich (20a, 20b) des Substrats, wobei die Führungsanordnung eine Schicht umfasst, in der Öffnungen gebildet sind und einen Öffnungsgrad in dem ersten oberen Bereich (20a) des zweiten Bereichs (20b) aufweisen;
- Aufbringen (F3) einer Schicht aus Block-Kopolymeren (4) auf dem Substrat (2) derart, dass die Schicht aus Block-Kopolymeren (4) vollständig die Öffnungen der Führungsanordnung (1) füllt und eine Überdicke auf der Führungsanordnung bildet;
- Assemblieren (F4) des Block-Kopolymers, aus der ein Abschnitt (4a) der Schicht aus Block-Kopolymeren resultiert, der sich im Innern der Öffnungen (10) der Führungsanordnung (1) befindet und gemäß einem gewünschten Motiv organisiert ist;
- Gleichmäßiges Ausdünnen (F5) der Schicht aus Block-Kopolymeren (4), bis eine Schicht erreicht wird, die dem organisierten Abschnitt (4a) der Schicht aus Block-Kopolymeren entspricht;
- Entfernen (F6) einer der Phasen (41) des montierten Block-Kopolymers, woraus eine Vielzahl von anfänglichen Motiven (43) resultiert, die sich in der Schicht aus Block-Kopolymeren (42) erstreckt; und
- Übertragen (F7) der anfänglichen Motive (43) von der Schicht aus Block-Kopolymeren (42) auf das Substrat (2), um die genannten endgültigen Motive (21) zu formen.

2. Verfahren gemäß Anspruch 1, bei dem das Aufbringen (F3) der Schicht aus Block-Kopolymeren (4) durch Zentrifugalbeschichtung realisiert ist.

3. Verfahren gemäß einem der Ansprüche 1 und 2, bei dem das Block-Kopolymer wenigstens ein Styrolderivat und ein Methacrylat enthält.

4. Verfahren gemäß irgendeinem der Ansprüche 1 bis 3, bei dem das Ausdünnen (F5) der Schicht aus Block-Kopolymeren (4) per Plasmagravur realisiert ist.

5. Verfahren gemäß Anspruch 4, bei dem das Ausdünnen (F5) der Schicht aus Block-Kopolymeren (4) und das Entfernen (F6) einer der Phasen (41) des montierten Block-Kopolymers in einem und demselben Plasmagravur-Rahmen realisiert sind.

6. Verfahren gemäß Anspruch 5, bei dem das Ausdünnen (F5) der Schicht aus Block-Kopolymeren (4) und das Entfernen (F6) einer der Phasen (41) des Block-Kopolymers gleichzeitig unter Verwendung eines einzigen Plasmas realisiert sind, das ausgewählt ist aus $Ar/O_2$, $SF_6$, $C_xF_y$, $N_2/H_2$, $CO/O_2$, $CO/H_2$, $CH_4/O_2$, $C_xF_y/O_2$, $CH_xF_y/O_2$, $C_xF_y/H_2$, $CH_xF_y/H_2$ und $C_xH_y/H_2$.

7. Verfahren gemäß Anspruch 5, bei dem das Ausdünnen (F5) der Schicht aus Block-Kopolymeren (4) und das Entfernen (F6) einer der Phasen (41) des montierten Block-Kopolymers durch eine Folge von Schritten realisiert ist, die Plasma unterschiedlicher Arten oder per Alternation von wenigstens zwei Phasen verwenden.

**8.** Verfahren gemäß irgendeinem der Ansprüche 1 bis 7, bei dem das Ausdünnen (F5) der Kopolymerschicht (4) per mechanisch-chemischem Polieren realisiert ist.

**9.** Verfahren gemäß irgendeinem der Ansprüche 1 bis 8, bei dem die Führungsanordnung (1) aus einer Maske gebildet ist, die auf dem Substrat (2) aufgebracht und per Photolithographie und /oder Gravur strukturiert ist.

**10.** Verfahren gemäß Anspruch 9, bei dem die Maske (1) eine erste kohlenstoffhaltige Schicht (11) in Kontakt mit dem Substrat (2) und eine zweite anti-reflektorische, siliziumreiche Schicht (12) hat, die auf der ersten kohlenstoffhaltigen Schicht (11) aufgebracht ist, wobei die genannte anti-reflektorische, siliziumreiche Schicht (12) als Stopp-Schicht beim Ausdünnen (F5) der Schicht aus montiertem Block-Kopolymer dient.

**11.** Verfahren gemäß irgendeinem der Ansprüche 1 bis 10, bei dem die Führungsanordnung (1) eine Vielzahl von Öffnungen umfasst, die Führungsmotive (10) bilden, welche zwischen dem ersten und zweiten Bereich (20a, 20b) des Substrats (2) verteilt sind.

**12.** Verfahren gemäß Anspruch 11, bei dem die Führungsmotive (10) eine zwischen 5 nm und 1000 nm inbegriffene Höhe haben.

**13.** Verfahren gemäß einem der Ansprüche 11 und 12, bei dem die Oberfläche der Führungsmotive (10) eine besondere Affinität für einen oder mehrere der Blöcke des Block-Kopolymers aufweist.

**14.** Verfahren gemäß einem der Ansprüche 11 und 12, bei dem der Boden der Führungsmotive (10) im Verhältnis zu den Blöcken des Block-Kopolymers neutral ist und bei dem die Flanken der Führungsmotive (10) eine besondere Affinität für einen oder mehrere der Blöcke des Block-Kopolymers aufweisen.

**15.** Verfahren gemäß einem der Ansprüche 11 und 12, bei dem die Oberfläche der Führungsmotive (10) im Verhältnis zu den Blöcken des Block-Kopolymers neutral ist.

**16.** Verfahren gemäß einem der Ansprüche 13 und 14, bei dem die besondere Affinität der Führungsanordnung (1) für einen oder mehrere Blöcke des Block-Kopolymers per Aufpfropfen eines oder mehrerer Homopolymere erhalten wird.

**17.** Verfahren gemäß einem der Ansprüche 14 und 15, bei dem die Neutralisierung der Führungsanordnung (1) per Aufpfropfen eines statistischen Kopolymers erhalten wird.

**Claims**

**1.** Method for producing final patterns (21) on the surface of a substrate (2) by self-assembly of a block copolymer, comprising the following steps:

- forming (F1) an assembly guide (1) on first and second areas (20a, 20b) of the substrate, the assembly guide comprising a layer in which openings are formed and having an opening ratio in the first area (20a) greater than that of the second area (20b);
- depositing (F3) a block copolymer layer (4) on the substrate (2), such that the block copolymer layer (4) entirely fills the openings of the assembly guide (1) and forms an over-thickness on the assembly guide;
- assembling (F4) the block copolymer, resulting in an portion (4a) of the block copolymer layer located inside the openings (10) of the assembly guide (1) and organised according to a desired pattern;
- thinning (F5) uniformly the block copolymer layer (4), until a thickness corresponding to the organised portion (4a) of the block copolymer layer is reached;
- eliminating (F6) one of the phases (41) of the assembled block copolymer, resulting in a plurality of initial patterns (43) extending into the block copolymer layer (42); and
- transferring (F7) the initial patterns (43) of the block copolymer layer (42) into the substrate (2) to form said final patterns (21).

**2.** Method according to claim 1, wherein the deposition (F3) of the block copolymer layer (4) is carried out by spin coating.

**3.** Method according to one of claims 1 and 2, wherein the block copolymer contains at least one styrene derivative and one methacrylate derivative.

**4.** Method according to any one of claims 1 to 3, wherein the thinning (F5) of the block copolymer layer (4) is carried out by plasma etching.

**5.** Method according to claim 4, wherein the thinning (F5) of the block copolymer layer (4) and the elimination (F6) of one of the phases (41) of the assembled block copolymer are carried out in a same plasma etching apparatus.

**6.** Method according to claim 5, wherein the thinning (F5) of the block copolymer layer (4) and the elimination (F6) of one of the phases (41) of the assembled block copolymer are carried out simultaneously using a single plasma selected from $Ar/O_2$, $SF_6$, $C_x F_y$, $N_2/H_2$, $CO/O_2$, $CO/H_2$, $CH_4/O_2$, $C_x F_y/O_2$, $CH_x$-

$F_y/O_2$, $C_xF_y/H_2$, $CH_xF_y/H_2$ and $C_xH_y/H_2$.

7. Method according to claim 5, wherein the thinning (F5) of the block copolymer layer (4) and the elimination (F6) of one of the phases (41) of the assembled block copolymer are carried out by a succession of steps using plasmas of different types or by alternation of at least two plasmas.

8. Method according to any one of claims 1 to 7, wherein the thinning (F5) of the layer of copolymer (4) is carried out by chemical mechanical planarization.

9. Method according to any one of claims 1 to 8, wherein the assembly guide (1) is formed of a mask arranged on the substrate (2) and textured by photolithography and/or etching.

10. Method according to claim 9, wherein the mask (1) comprises a first carbonaceous layer (11) in contact with the substrate (2) and a second anti-reflective silicon rich layer (12) arranged on the first carbonaceous layer (11), said anti-reflective silicon rich layer (12) serving as stop layer during the thinning (F5) of the assembled block copolymer layer.

11. Method according to any one of claims 1 to 10, wherein the assembly guide (1) comprises a plurality of openings forming guiding patterns (10) distributed between the first and second areas (20a, 20b) of the substrate (2).

12. Method according to claim 11, wherein the guiding patterns (10) have a height comprised between 5 nm and 1000 nm.

13. Method according to one of claims 11 and 12, wherein the surface of the guiding patterns (10) has a particular affinity for one or more of the blocks of the block copolymer.

14. Method according to one of claims 11 and 12, wherein the bottom of the guiding patterns (10) is neutral with respect to the blocks of the block copolymer, and wherein the sides of the guiding patterns (10) have a particular affinity for one or more of the blocks of the block copolymer.

15. Method according to one of claims 11 and 12, wherein the surface of the guiding patterns (10) is neutral with respect to the blocks of the block copolymer.

16. Method according to one of claims 13 and 14, wherein the particular affinity of the assembly guide (1) for one or more blocks of the block copolymer is obtained by grafting of one or more homopolymers.

17. Method according to one of claims 14 and 15, wherein the neutralisation of the assembly guide (1) is obtained by grafting of a random copolymer.

-F1-

1a

10      10      10      10

12

1

11

2

20b              20a

**Fig. 1A**

-F2-

1a

10      10      10      10

1

2

3

**Fig. 1B**

-F3-

w

10                      10

4

hf

1

h

2

20b              20a

**Fig. 1C**

Fig. 1D

Fig. 1E

Fig. 1F

Fig. 1G

Fig. 2

Fig. 3A

Fig. 3B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2014021166 A

- US 2014057443 A

**Littérature non-brevet citée dans la description**

- **L. ORIA et al.** Guided self-assembly of block-copolymer for CMOS technology: a comparative study between grapho-epitaxy and surface chemical modification. *SPIE,* 2011, vol. 7970-24
- **P. PIMENTA BARROS et al.** Etch challenges for DSA implementation in CMOS via patterning. *SPIE Proceedings,* Mars 2014, vol. 9054

- Planarization of Substrate Topography by Spin Coating. *J. Electrochem. Soc.,* 1987, vol. 134 (8), 2030-2037
- A Parametric Study of Spin Coating over Topography. *Ind. Eng. Chem. Res.,* 1998, vol. 37 (6), 2223-2227
- Characteristics of resist films produced by spinning. *J. Appl. Phys.,* 07 Juillet 1978, vol. 49